Europäisches Patentamt

European Patent Office

Office européen des brevets

(11) Veröffentlichungsnummer: **0 270 940**
**B1**

(12) **EUROPÄISCHE PATENTSCHRIFT**

(45) Veröffentlichungstag der Patentschrift: **30.01.91**

(21) Anmeldenummer: **87117517.0**

(22) Anmeldetag: **26.11.87**

(51) Int. Cl.$^5$: **H 02 H 7/12, H 03 K 17/08**

(54) Schaltungsanordnung zur Begrenzung von Überspannungen an einem Stromrichterventil und zur Stromversorgung einer Ansteuerschaltung des zu schützenden Stromrichterventils.

(30) Priorität: **09.12.86 DE 3642027**

(43) Veröffentlichungstag der Anmeldung:
**15.06.88 Patentblatt 88/24**

(45) Bekanntmachung des Hinweises auf die
Patenterteilung:
**30.01.91 Patentblatt 91/05**

(84) Benannte Vertragsstaaten:
**AT DE FR GB IT NL SE**

(56) Entgegenhaltungen:
**DE-A-3 215 589**
**DE-A-3 513 239**
**GB-A-2 105 927**

(73) Patentinhaber: **Siemens Aktiengesellschaft**
**Wittelsbacherplatz 2**
**D-8000 München 2 (DE)**

(72) Erfinder: **Drescher, Hans**
**Skraupstrasse 24**
**A-1210 Wien (AT)**
Erfinder: **Winterstein, Thomas, Dipl.-Ing. (FH)**
**Am Europakanal 4**
**D-8520 Erlangen (DE)**

Courier Press, Leamington Spa, England.

**Beschreibung**

Die Erfindung bezieht sich auf eine Schaltungsanordnung zur Begrenzung von Überspannungen an einem Stromrichterventil mittels einer RC-Beschaltung und zur Stromversorgung einer Ansteuerschaltung des zu schützenden Stromrichterventils, bestehend aus einer ersten Diode und einer Reihenschaltung aus einem Widerstand und einem Kondensator, dem eine Zener-Diode elektrisch parallel geschaltet ist (GB-A-2105927).

Eine Schaltungsanordnung zur Begrenzung von Überspannungen an einem Stromrichterventil mittels einer RC-Beschaltung ist im Handel erhältlich. Dabei begrenzt der Kondensator der RC-Beschaltung beim Abschalten des Stromrichterventils die entstehende Überspannung und nimmt dabei elektrische Energie auf. Die Überspannung entsteht durch die Stromänderung an parasitären Induktivitäten beim Schalten. Die elektrische Energie, die der Kondensator der RC-Beschaltung aufnehmen muß, ist vom verwendeten Stromrichterventil und den parasitären Induktivitäten abhängig. Beim Wiedereinschalten des Stromrichterventils entlädt sich der Kondensator über den Widerstand der RC-Beschaltung. Dabei treten im Widerstand Verluste auf, die proportional der Schaltfrequenz, der Kapazität des Kondensators und dem Quadrat der Ladespannung des Kondensators sind.

Eine weitere Schaltungsanordnung zur Begrenzung von Überspannungen an einem Stromrichterventil mittels einer RCD-Beschaltung ist im Handel erhältlich. Dabei ist dem Widerstand der RC-Beschaltung eine Diode parallel geschaltet. Diese Diode soll den Widerstand vor unerwünscht hohen Verlusten schützen, die bei Verwendung des Stromrichterventils in Mittelfrequenzanlagen und in Anlagen mit stark pulsierender Anodenspannung entstehen können.

Außerdem ist eine Schaltungsanordnung zur Stromversorgung einer Ansteuerschaltung eines Stromrichterventils im Handel erhältlich.

Diese Schaltungsanordnung enthält eine Reihenschaltung aus einer ersten Diode, einem Widerstand und einem Kondensator, dem eine Zener-Diode elektrisch parallel geschaltet ist. Diese Reihenschaltung ist dem Stromrichterventil elektrisch parallel geschaltet. Mit dieser Schaltungsanordnung wird die Stromversorgung für die Ansteuerschaltung des Stromrichterventils aus einer Eingangsspannung erzeugt. Dabei fließt immer dann ein Ladestrom in den Kondensator, wenn das parallel geschaltete Stromrichterventil abgeschaltet ist. Die am Kondensator aufgebaute Spannung wird durch die Zener-Diode begrenzt. Der Widerstand dieser Reihenschaltung ist so bemessen, daß selbst bei Unterspannung der Eingangsspannung der Versorgungsstrom für die Ansteuerschaltung des Stromrichterventils geliefert werden kann. Somit können hohe Verluste an diesem Widerstand im zulässigen Eingangsspannungsbereich entstehen.

Der Erfindung liegt nun die Aufgabe zugrunde, eine Schaltungsanordnung zur Begrenzung von Überspannungen an einem Stromrichterventil und zur Stromversorgung einer Ansteuerschaltung des zu schützenden Stromrichterventils anzugeben, bei der die gespeicherte elektrische Energie im Kondensator der RC-Beschaltung für die Stromversorgung der Ansteuerschaltung wenigstens teilweise ausgenutzt werden kann.

Diese Aufgabe wird erfindungsgemäß dadurch gelöst, daß der widerstandsseitige Anschluß der RC-Beschaltung mit der Kathode der ersten Diode verknüpft ist, wobei die Anode der Diode mit der Anode des Stromrichterventils und die Kathode des Stromrichterventils mit dem kondensatorseitigen Anschluß der RC-Beschaltung verbunden ist, daß die Reihenschaltung elektrisch parallel zum Kondensator der RC-Beschaltung geschaltet ist, und daß die Stromversorgungsanschlüsse der Ansteuerschaltung mit den Anschlüssen des mit der Zener-Diode versehenen Kondensators verknüpft sind, wobei der Ausgang der Ansteuerschaltung mit dem Steuereingang des Stromrichterventils verbunden ist.

Durch diese erfindungsgemäße Ausgestaltung der Schaltungsanordnung wird wenigstens ein Teil der im Kondensator der RC-Beschaltung gespeicherten elektrischen Energie für die Stromversorgung der Ansteuerschaltung ausgenutzt. In Abhängigkeit der Kondensatorspannung des Kondensators der RC-Beschaltung und der durch die Zener-Diode begrenzte Kondensatorspannung gelangt Ladung vom Kondensator der RC-Beschaltung zum Kondensator der Stromversorgung. Durch die Kapazität des Kondensators der RC-Beschaltung und durch die am Kondensator der Stromversorgung der Ansteuerschaltung begrenzten Kondensatorspannung, wird der Anteil der gespeicherten elektrischen Energie im Kondensator der RC-Beschaltung bestimmt, der für die Stromversorgung der Ansteuerschaltung ausgenutzt werden kann. Dies führt einerseits zu einer geringeren Verlustleistung am Widerstand der RC-Beschaltung und andererseits wird der Kondensator dieser Beschaltung nicht vollständig entladen, das zu einer weiteren Verlustleistungsreduktion beiträgt.

In einer vorteilhaften Ausführungsform der Schaltungsanordnung ist der widerstandsseitige Anschluß der Reihenschaltung mit der Kathode einer zweiten Diode verknüpft, deren Anode einerseits mit dem Verbindungspunkt von Widerstand und Kondensator der RC-Beschaltung und andererseits über einen Widerstand mit der Anode der ersten Diode verknüpft ist. Durch diese Ausgestaltung wird der Kondensator bei Wiedereinschalten des Stromrichterventils vollständig entleert, wobei die Ladung dieses Kondensators einerseits zum Kondensator der Stromversorgung der Ansteuerschaltung gelangt und andererseits über den Widerstand, der elektrisch parallel zur Reihenschaltung aus der ersten Diode und dem Widerstand der RC-Beschaltung angeordnet ist, abfließt. Dabei bestimmt der Widerstand den Anteil der Ausnutzung der in dem Kondensator der RC-Beschaltung gespeicherten elektrischen Energie. Die zweite Diode verhindert ein Entladen des Kondensators der Stromversorgung der Ansteuerschaltung während des Wiedereinschaltens des Stromrichterventils.

Zur weiteren Erläuterung der Erfindung wird auf die Zeichnung Bezug genommen, in der Ausführungsbeispiele der Erfindung schematisch veranschaulicht sind.

FIG. 1 zeigt eine Schaltungsanordnung zur Begrenzung von Überspannungen an einem Stromrichterventil und zur Stromversorgung einer Ansteuerschaltung des Stromrichterventils nach der Erfindung und in

FIG. 2 ist eine vorteilhafte Ausführungsform der Schaltungsanordnung dargestellt.

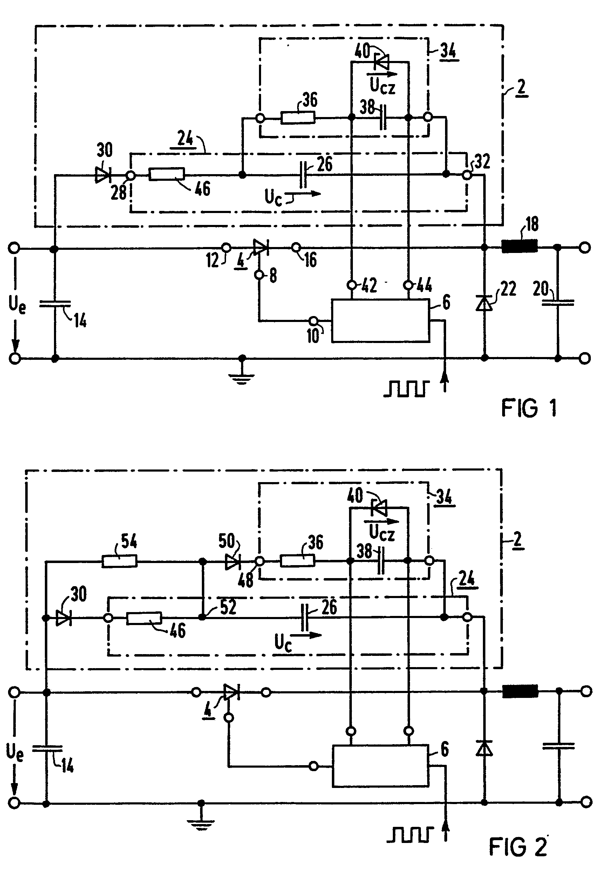

In FIG. 1 ist eine Schaltungsanordnung 2 zur Begrenzung von Überspannungen an einem Stromrichterventil 4 und zur Stromversorgung einer Ansteuerschaltung 6 des zu schützenden Stromrichterventils 4 dargestellt. Die Schaltungsanordnung 2 ist elektrisch parallel zum Stromrichterventil 4 geschaltet. Als Stromrichterventil 4 kann man einen Schalttransistor, einen Thyristor oder einen Gate-turn-off-Thyristor verwenden. Der Steuereingang 8 des Stromrichterventils 4 ist mit dem Ausgang 10 der Ansteuerschaltung 6 verknüpft. Der Anode 12 des Stromrichterventils 4 wird über einen Eingangskondensator 14 einer Eingangsspannung $U_e$ zugeführt. Die Kathode 16 des Stromrichterventils 4 ist einerseits über eine Induktivität 18 mit einem Ausgangskondensator 20 und andererseits über eine Freilaufdiode 22 mit dem Massepotential verknüpft. Beim Abschalten des Stromrichterventils 4 entsteht infolge der parasitären Induktivität, die im Hauptstromkreis, bestehend aus dem Eingangskondensator 14, dem Stromrichterventil 4 und der Freilaufdiode 22, entsteht und der endlichen Kommutierungszeit des Stromes vom Stromrichterventil 4 auf die Freilaufdiode 22 eine Überspannung. Diese entstehende Überspannung wird durch eine RC-Beschaltung 24 begrenzt. Dabei nimmt der Kondensator 26 der RC-Beschaltung 24 elektrische Energie auf. Der widerstandsseitige Anschluß 28 der RC-Beschaltung 24 ist mit der Kathode einer ersten Diode 30 verbunden, deren Anode mit der Anode 12 des Stromrichterventils 4 verknüpft ist. Der kondensatorseitige Anschluß 32 dieser RC-Beschaltung 24 ist mit der Kathode 16 des Stromrichterventils 4 verbunden. Elektrisch parallel zum Kondensator 26 der RC-Beschaltung 24 ist eine Reihenschaltung 34 geschaltet, die aus einem Widerstand 36 und einem Kondensator 38 besteht. Dem Kondensator 38 ist eine Zener-Diode 40 elektrisch parallel geschaltet, die die Kondensatorspannung $U_{cz}$ auf einen vorbestimmten Wert, nämlich die Versorgungsspannung der Ansteuerschaltung 6, begrenzt. Deshalb sind die Stromversorgungsanschlüsse 42 und 44 der Ansteuerschaltung 6 mit den Anschlüssen des Kondensators 38 der Reihenschaltung 34 verknüpft.

Beim eingeschalteten Stromrichterventil 4 ist die Schaltungsanordnung 2 zur Begrenzung von Überspannungen und zur Stromversorgung der Ansteuerschaltung 6 des zu schützenden Stromrichterventils 4 kurzgeschlossen. Beim Abschalten entsteht durch die endliche Kommutierungszeit des Stromes vom Stromrichterventil 4 auf die Freilaufdiode 22, durch die Induktivität 18 und durch die parasitären Induktivitäten eine Überspannung. Diese Überspannung wird durch die Kapazität des Kondensators 26 der RC-Beschaltung 24 begrenzt. D.h., es fließt solange ein Ladestrom über die erste Diode 30 und den Widerstand 46 in den Kondensator 26, bis die parasitäre Induktivität entladen ist. Im geladenen Zustand steht am Kondensator 26 eine Spannung $U_c$ an, die sich aus der Eingangsspannung $Üe$ und einer dynamischen Spannungserhöhung zur Amplitude der Überspannung ergibt. Diese dynamische Spannungserhöhung resultiert aus dem Umschwingen der in der parasitären Induktivität gespeicherten Energie in den Kondensator 26. Außerdem wird während der Ausschaltphase des Stromrichterventils 4 der Kondensator 38 der Reihenschaltung 34 auf- und/oder nachgeladen, wobei die am Kondensator 38 anstehende Spannung durch die Zener-Diode 40 begrenzt ist. Die Stromversorgung der Ansteuerschaltung 6 erfolgt immer aus dem Kondensator 38 der Reihenschaltung 34.

Beim Wiedereinschalten des Stromrichterventils 4 entlädt sich der Kondensator 26 der RC-Beschaltung 24 teilweise in den Kondensator 38. Durch den Spannungsunterschied der Spannung $U_c$ und der Spannung $U_{cz}$ wird die Ausnutzung der im Kondensator 26 gespeicherten elektrischen Energie bestimmt. Wenn die verbleibende gespeicherte elektrische Energie im Kondensator 26 und damit die Spannung $U_c$ am Kondensator 26 größer ist als die Kondensatorspannung $U_{cz}$ des Kondensators 38, so kann während der Einschaltphase des Stromrichterventils 4 der Kondensator 38 solange nachgeladen werden, bis die Spannung $U_c$ gleich ist der Spannung $U_{cz}$. Ist die Spannung $U_c$ am Kondensator 26 gleich der Spannung $U_{cz}$, kann während der Einschaltphase nicht mehr nachgeladen werden. Der zeitliche Abstand zwischen Einschalten und Ausschalten des Stromrichterventils 4 wird durch eine nicht näher bezeichnete Taktfrequenz bestimmt, die einem Takteingang der Ansteuerschaltung 6 zugeführt wird.

Somit erhält man eine Schaltungsanordnung 2 zur Begrenzung von Überspannungen an einem Stromrichterventil 4 und zur Stromversorgung seiner Ansteuerschaltung 6, bei der wenigstens ein Teil der im Kondensator 26 der RC-Beschaltung 24 gespeicherten elektrischen Energie für die Stromversorgung der Ansteuerschaltung 6 ausgenutzt wird.

In FIG. 2 ist eine vorteilhafte Ausführungsform der Schaltungsanordnung 2 veranschaulicht. Bei dieser Schaltungsanordnung 2 ist der widerstandsseitige Anschluß 48 der Reihenschaltung 34 mit der Kathode einer zweiten Diode 50 verknüpft. Die Anode dieser Diode 50 ist einerseits mit dem Verbindungspunkt 52 vom Widerstand 46 und Kondensator 26 der RC-Beschaltung 24 und andererseits über einen Widerstand 54 mit der Anode der ersten Diode 30 verknüpft.

Beim Abschalten des Stromrichterventils 4 wird der Kondensator 26 der RC-Beschaltung 24 über die erste Diode 30 und den Widerstand 46 geladen, wodurch die anstehende Überspannung begrenzt wird. Außerdem wird der Kondensator 38, dem die Zener-Diode 40 elektrisch parallel geschaltet ist, über die erste Diode 30, den Widerstand 46, den Widerstand 54, die zweite Diode 50 und den Widerstand 36 geladen. Die Spannung $U_{cz}$ am Kondensator 38 wird durch die Zener-Diode 40 begrenzt.

Beim Wiedereinschalten des Stromrichterventils 4 entlädt sich der Kondensator 26 einerseits über die zweite Diode 50 und den Widerstand 36 in den Kondensator 38 und andererseits über den Widerstand 54. Der Widerstand 54 bestimmt, inwieweit sich der Kondensator 26 der RC-Beschaltung 24 in den Kondensator 38 entlädt, und bestimmt somit die Ausnutzung der im Kondensator 26 gespeicherten elektrischen Energie zur Stromversorgung der Ansteuerschaltung 6. Sobald die Spannung $U_{cz}$ am Kondensator 38 gleich der Spannung $U_c$ am Kondensator 26 der RC-Beschaltung 24 ist, fließt die noch auf dem Kondensator 26 vorhandene Ladung über den Widerstand 54 ab. Dabei wird die Entladezeit durch den Widerstand 54 und dem Kondensator 26 bestimmt. Somit erhält man eine Schaltungsanordnung 2 zur Begrenzung von Überspannungen am Stromrichterventil 4 und zur Stromversorgung seiner Ansteuerschaltung 6, bei der der Kondensator 26 der RC-Beschaltung 24 beim Wiedereinschalten des Stromrichterventils 4 vollständig entladen sein kann.

**Patentansprüche**

1. Schaltungsanordnung (2) zur Begrenzung von Überspannungen an einem Stromrichterventil (4) mittels einer RC-Beschaltung (24) und zur Stromversorgung einer Ansteuerschaltung (6) des zu schützenden Stromrichterventils (4), bestehend aus einer ersten Diode (30) und einer Reihenschaltung (34) aus einem Widerstand (36) und einem Kondensator (38), dem eine Zener-Diode (40) elektrisch parallel geschaltet ist, dadurch gekennzeichnet, daß der widerstandsseitige Anschluß (28) der RC-Beschaltung (24) mit der Kathode der ersten Diode (30) verknüpft ist, wobei die Anode der ersten Diode (3D) mit der Anode (12) des Stromrichterventils (4) und die Kathode (16) des Stromrichterventils (4) mit dem kondensatorseitigen Anschluß (32) der RC-Beschaltung (24) verbunden ist, daß die Reihenschaltung (34) elektrisch parallel zum Kondensator (26) der RC-Beschaltung (24) geschaltet ist, und daß die Stromversorgungsanschlüsse (42, 44) der Ansteuerschaltung (6) mit den Anschlüssen des mit der Zener-Diode (40) versehenen Kondensators (38) verknüpft sind, wobei der Ausgang (10) der Ansteuerschaltung (6) mit dem Steuereingang (8) des Stromrichterventils (4) verbunden ist.

2. Schaltungsanordnung (2) nach Anspruch 1, dadurch gekennzeichnet, daß der widerstandsseitige Anschluß (48) der Reihenschaltung (34) mit der Kathode einer zweiten Diode (50) verknüpft ist, deren Anode einerseits mit dem Verbindungspunkt (52) vom Widerstand (46) und Kondensator (26) der RC-Beschaltung (24) und andererseits über einen Widerstand (54) mit der Anode der ersten Diode (3D) verknüpft ist.

**Revendications**

1. Montage (2) pour limiter des surtensions dans une valve (4) redresseuse à l'aide d'un circuit RC (24) et pour alimenter en courant un circuit (6) de commande de la valve redresseuse (4), qui doit être protégée, et constitué par une première diode (30) et un circuit série (34), formé d'une résistance (36) et d'un condensateur (38), en parallèle avec lequel est branchée électriquement une diode Zener (40), caractérisé par le fait que la borne (28), située du côté de la résistance, du circuit RC (24) est raccordée à la cathode de la première diode (30), dont l'anode est reliée à l'anode (12) de la valve redresseuse (4), dont la cathode (16) est raccordée à la borne (32), située du côté du condensateur, du circuit RC (24), que le circuit série (34) est branché électriquement en parallèle avec le condensateur (26) du circuit RC (24) et que les bornes d'alimentation en courant (42, 44) du circuit de commande (6) sont combinées aux bornes du condensateur (38) équipé de la diode Zener (40), la sortie (10) du circuit de commande (6) étant raccordée à l'entrée de commande (8) de la valve redresseuse (4).

2. Montage (2) suivant la revendication 1, caractérisé par le fait que la borne (48), située du côté de la résistance, du circuit série (34) est raccordée à la cathode d'une seconde diode (50), dont l'anode est raccordée, d'une part, à un point de jonction (52) entre la résistance (46) et le condensateur (26) du circuit RC (24), et, d'autre part, par l'intermédiaire d'une résistance (54), à l'anode de la première diode (30).

**Claims**

1. A circuit arrangement for limiting overvoltages at a rectifier valve (4) by means of an RC-circuit (24) and for the power supply of a control circuit (6) of the rectifier valve (4) to be protected, consisting of a first diode (30) and a series circuit (34) of a resistor (36) and a capacitor (38) with which a Zener diode (40) is connected electrically in parallel, characterised in that the resistor-side terminal (28) of the RC-circuit (24) is linked with the cathode of the first diode (30), the anode of the first diode (30) being connected to the anode (12) of the rectifier valve (4) and the cathode (16) of the rectifier valve (4) to the capacitor-side terminal (32) of the RC-circuit (24), in that the series circuit (34) is connected electrically in parallel with the capacitor (26) of the RC-circuit (24), and in that the power supply terminals (42, 44) of the control circuit (6) are connected to the terminals of the capacitor (38) provided with the Zener diode (40), the output (10) of the control circuit (6) being connected to the control input (8) of the rectifier valve (4).

2. A circuit arrangement (2) according to claim 1, characterised in that the resistor-side terminal (48) of the series circuit (34) is linked to the cathode of a second diode (50), the anode of which is linked, on the one hand, to the interconnecting point (52) of the resistor (46) and capacitor (26) of the RC-circuit (24) and, on the other hand, by way of a resistor (54) to the anode of the first diode (30).

FIG 1

FIG 2